# EUROPEAN PATENT APPLICATION

(11) **EP 4 835 391 A1**
(43) Date of publication of application: **04.11.2026**
(21) Application number: 25173712.8
(22) Date of filing: 30.04.2025
(51) Int. Cl.: F28D 15/04, F28F 21/00

(54) **GLASS HEAT PIPES**

(71) Applicant: SCHOTT AG, 55122 Mainz (DE)
(72) Inventor: STEDEN, Folker, 95666 Mitterteich (DE)
(74) Representative: Schott Corporate IP

(57) **Abstract**

The present invention refers to a heat pipe comprising a glass tubular body comprising a first closed end, a second closed end and a transfer section, wherein the inner surface of the tubular body encloses an interior space, a fiberglass braided sleeve within the enclosed interior space of the tubular body, wherein the fiberglass braided sleeve comprises strands of fiberglass spirally braided in the longitudinal direction of the sleeve, and a working fluid in the enclosed interior space of the tubular body. Furthermore, the present invention refers to a method for preparing such heat pipes as well as the use of such heat pipes for cooling.

## Description

### Field of the Invention

The present invention refers to a heat pipe comprising a glass tubular body comprising a first closed end, a second closed end and a transfer section, wherein the inner surface of the tubular body encloses an interior space, a fiberglass braided sleeve within the enclosed interior space of the tubular body, wherein the fiberglass braided sleeve comprises strands of fiberglass spirally braided in the longitudinal direction of the sleeve, and a working fluid in the enclosed interior space of the tubular body. Furthermore, the present invention refers to a method for preparing such heat pipes as well as the use of such heat pipes for cooling.

### Prior art

A heat pipe is a heat-transfer device that employs phase transition to transfer heat between two solid interfaces. The working mechanism of such heat pipes has been known for several decades and has been first described in US2350348. In particular US2350348 describes a method of transferring heat from one point to another by means of a closed system wherein a volatile liquid is successively evaporated and condensed at substantially the same pressure which comprises evaporating the liquid refrigerant at one level, condensing the vapor at another level below the point at which evaporation takes place, and returning the liquid from the point of condensation to the point of evaporation by capillary action.

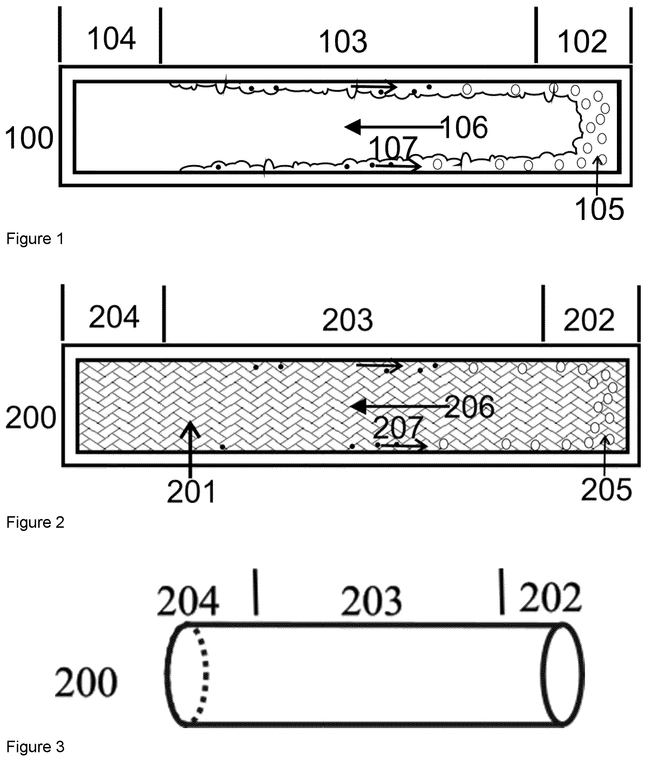

The operation principle of such a heat pipe is shown in Figure 1. The heat pipe comprises a sealed pipe or tube (100) which is sealed in a condition of a vacuum. Furthermore, the heat pipe comprises inside the sealed pipe or tube (100) a fluid (105) carrying heat. The fluid carrying heat is vaporized at vaporization zone (102), and the vapor (106) flows through the transportation zone (103) toward the opposite end of the heat pipe in the condensation zone (104) and radiates the heat in the condensation zone (104). Afterwards, the fluid is recirculated (107) back to the vaporization zone (102) along the surface of the wall of the heat pipe (100). Recirculation can be forced, for example, by capillary action, centrifugal force, or gravity.

In order to influence the efficiency of such a heat pipe often a structure is located in the heat pipe. The structure should improve the circulation inside the heat pipe. Such structures are known, for example from DE4130976, that refers to heat pipe, characterized in that it consists of a composite of aluminum and a fiber composite material, wherein its inner profile is formed from aluminum and the fiber composite material is embedded in recesses of the aluminum. DE202024101258U1 refers to a planar heat pipe comprising a mesh within the heat pipe. JP2004332975A refer to a heat pipe comprising a net-like structure, for example, a non-woven sheet. US 2024361085 refers to glass fiber heat pipes and wicks for heat pipes. However, these heat pipes are often very large, intricately constructed, or made of expensive or harmful or toxic materials.

In view of the foregoing, there is a continuous need for improved heat pipes. Furthermore, there are several new possible fields of use for such heat pipes and, accordingly, the heat pipes must be continuously adapted and improved in order to be used in such areas. Especially when used in electronic devices such as wearable devices, portable devices or especially mobile devices it is necessary to provide heat pipes that are robust, very small and are radio frequency (RF) compatible. Compatibility with RF is often a problem with conventional heat pipes that are produced from metal compounds such as metal tubes like aluminum tubes or metal foils, meshes or wires such as copper meshes.

Accordingly, it is an object of the present invention to provide a heat pipe that can be used instead of the existing heat pipes known in the prior art. Furthermore, it is desirable to provide a heat pipe that performs similar or even more effectively than the existing ones, when having the same or similar or even smaller proportions. Additionally, it is desirable to provide a heat pipe that is made of sustainable materials that do not contain metals in order to avoid the heat pipe to interfere with radio frequencies that are received by electronic devices wherein the heat pipes are used. Furthermore, it is desirable to provide heat pipes that are easy to manufacture, inexpensive and do not contain any toxic or hazardous substances.

The foregoing and other objects are solved by the subject-matter as defined herein in the independent claims.

According to one aspect of the present invention, a heat pipe is provided, comprising a) a glass tubular body comprising a first closed end, a second closed end and a transfer section, wherein the inner surface of the tubular body encloses an interior space, b) a fiberglass braided sleeve within the enclosed interior space of the tubular body, wherein the fiberglass braided sleeve comprises strands of fiberglass spirally braided in the longitudinal direction of the sleeve, and c) a working fluid in the enclosed interior space of the tubular body.

According to another embodiment of the present invention a method for preparing the inventive heat pipe is provided comprising the steps of A) providing a glass tube with a first open end and a second open end and a transfer section, B) providing a fiberglass braided sleeve, wherein the fiberglass braided sleeve comprises strands of fiberglass spirally woven in the longitudinal direction of the sleeve, C) providing a working fluid, D) inserting the fiberglass braided sleeve of step B) into the glass tube A), E) closing thermally the first open end of the glass tube, to obtain a one end closed glass tube, F) inserting the working fluid of step C) in the one end closed glass tube of step E) and evacuating the glass tube afterwards to obtain a filled glass tube and G) closing thermally the second end of the filled glass tube of step F).

According to another embodiment of the present invention, the inventive heat pipe is used for cooling, preferably for cooling of electronic components.

The inventors surprisingly found that the inventive heat pipes that can be used instead of the existing heat pipes known in the prior art. Furthermore, the inventors surprisingly found that due to the innovative materials and design, especially the fiberglass braided sleeve, the inventive heat pipe that performs similar or even more effectively than the existing ones, when having the same or similar or even smaller proportions. Furthermore, the heat pipe according to the present invention is made of sustainable materials that are non-toxic and environmentally friendly and do not comprise any hazardous substances. The inventors found that the inventive heat pipes are easy to manufacture, and standard equipment can be used and, therefore, such heat pipes are inexpensive. Finally, since the inventive heat pipes do not contain metals or only a reduced amount of metal, they can be used in electronic devices, since these electronic devices often interfere with radio frequencies, that are produced by known prior art heat pipes.

Advantageous embodiments of the present invention are defined in the corresponding sub-claims.

According to one embodiment of the present invention, at least a part of the fiberglass braided sleeve is in contact with the inner surface of the tubular body, preferably at least 40 % of the inner surface of the transfer section are in contact with the fiberglass braided sleeve, more preferably at least 60 %, and most preferably at least 80%.

According to another embodiment of the present invention, the glass tubular body i) has a ratio of diameter to length from 1:2.0 to 1:100, preferably from 1:2.5 to 1:80, more preferably from 1:5.0 to 1:60 and/or ii) has an oval or round profile and preferably has a round profile.

According to another embodiment of the present invention, the strands of the fiberglass braided sleeve comprise bundles of fibers preferably comprise at least 50 fibers, more preferably at least 100 fibers and most preferably at least 200 fibers and/or wherein the fibers have a diameter of 1 µm to 20 µm, preferably 2 µm to 15 µm and most preferably 3 µm to 10 µm.

According to another embodiment of the present invention, the fiberglass braided sleeve has a braiding angle between 30° to 80°, preferably between 40° to 60° and most preferably between 42° to 50°.

According to another embodiment of the present invention, i) the fiberglass braided sleeve has a torque of at least 0.1 cm/min, preferably at least 0.2 cm/min, more preferably at least 0.3 cm/min even more preferably 0.4 cm/min and most preferably 0.5 cm/min and/or ii) the fiberglass braided sleeve has a maximal torque of at least 5 cm, preferably at least 10 cm, even more preferably at least 15 cm and most preferably at least 20 cm. According to another embodiment of the present invention, the enclosed interior space in the glass tubular body is vacuumed and has a pressure of below 100 Pa, preferably below 1.0 Pa, more preferably below 0.1 Pa, even more preferably below1*10⁻⁶ Pa and even more preferably below 1*10⁻⁹ Pa.

According to another embodiment of the present invention, the working fluid i) is selected from water, alcohols, ketones, fluorocarbons and mixtures thereof, preferably is selected from water, ethanol, methanol, perfluorocarbons and mixtures thereof and/or ii) is present in the heat pipe in an amount of 0.005 µl/mm³ to 5.0 µl/ mm³, preferably in an amount of 0.010 µl/mm³ to 1.0 µl/mm³, even more preferably 0.015 µl/mm³ to 0.80 µl/mm³ and most preferably in an amount of 0.020 µl/mm³ to 0.50 µl/mm³.

According to another embodiment of the present invention, the heat pipe does not comprise any metal component.

According to another embodiment of the present invention, the heat pipe has a thermal conductivity of 0.2 W/mK, preferably of 0.5 W/mK, even more preferably of 0.8 W/mK and most preferably of 1.0 W/mK.

According to another embodiment of the present invention, the diameter of the fiberglass braided sleeve provided in method step B) is larger than the diameter of the transfer section of the glass tube provided in method step A).

According to another embodiment of the present invention, the inventive heat pipe is used in wearable devices, preferably a watch, a haptic feedback glove, a wristband, a belt, an armband, head-mounted devices, preferably an extended reality headset or glasses, portable devices, preferably a laptop computer, mobile devices, preferably a tablet or mobile phone, rollable or foldable devices, preferably foldable phones or e-readers.

It should be understood that for the purpose of the present invention, the following terms have the following meaning.

A "heat pipe" in the meaning of the present invention is a device that has high thermal conductivity along its lengths and can transfer heat from a concentrated heat source of a component that is in direct or indirect contact with the heat pipe to a colder part of that component that is in direct or indirect contact with the heat pipe. A "direct" contact of a component with a heat pipe is when the heat pipe contacts the component without any aids, tool or interlayers. An "indirect" contact of a component with a heat pipe is when the heat pipe is in contact with the component via an interlayer or tool such as, for example, heat paste or a metal cap that that is pushed over the ends of the heat pipe or glued to them.

A "glass tubular body" in the meaning of the present invention defines the outer and inner geometry of the heat pipe and also seals the interior space containing the fiberglass braided sleeve and the working fluid from the outside.

A "fiberglass braided sleeve" in the meaning of the present invention is a sleeve or hose made form braided fiberglass strands that comprise fiberglass fibers. Its construction involves braiding these strands into a tubular form, creating a sleeve that is flexible yet durable. Due to the braiding pattern the sleeve can expand and contract to accommodate irregular shapes and sizes. The braiding process ensures uniformity and strength throughout the sleeve.

A "working fluid" in the meaning of the present invention is a liquid within the heat pipe that absorbs heat at the evaporator end, where it vaporizes. The vapor then travels to the condenser end, where it releases the absorbed heat and condenses back into a liquid. This liquid is then returned to the evaporator end by capillary action, completing the cycle. This continuous process allows for efficient heat transfer along the length of the heat pipe.

A "liquid" in the meaning of the present invention is a substance that is fluid at room temperature and can flow freely. A "solid" in the meaning of the present invention is a substance that is not liquid and not gaseous at room temperature but has a defined shape and volume. The room temperature is defined as a temperature of 20 °C at an atmospheric pressure of 101325 Pa (1013.25 hPa).

The term "normal condition" in the meaning of the present invention refers to the room temperature of 20 °C (293.15 K, 68 °F) and an absolute atmospheric pressure of 1 atm (14.696 psi, 101.325 kPa).

Where the term "comprising" is used in the present description and claims, it does not exclude other elements. For the purposes of the present invention, the term "consisting of" is considered to be a preferred embodiment of the term "comprising of". If hereinafter a group is defined to comprise at least a certain number of embodiments, this is also to be understood to disclose a group, which preferably consists only of these embodiments.

Where an indefinite or definite article is used when referring to a singular noun, e.g. "a", "an" or "the", this includes a plural of that noun unless something else is specifically stated.

Terms like "obtainable" or "definable" and "obtained" or "defined" are used interchangeably. This e.g. means that, unless the context clearly dictates otherwise, the term "obtained" does not mean to indicate that e.g. an embodiment must be obtained by e.g. the sequence of steps following the term "obtained" though such a limited understanding is always included by the terms "obtained" or "defined" as a preferred embodiment.

### Figures

Figure 1 shows the operation principle of a regular heat pipe
Figure 2 shows a schematic drawing of a heat pipe according to the present invention
Figure 3 shows a schematic drawing of the glass tubular body according to the present invention
Figures 4a and 4b show a schematic drawing of the fiberglass braided sleeve according to the present invention

Preferred embodiments of the invention are shown in the figures and will be explained in more detail in the following description, wherein identical reference signs refer to identical or similar components or elements.

### Disclosure of the invention

According to the present invention, a heat pipe is provided, comprising a) a glass tubular body (200) comprising a first closed end (202), a second closed end (204) and a transfer section (203), wherein the inner surface of the tubular body encloses an interior space, b) a fiberglass braided sleeve (201) within the enclosed interior space of the tubular body, wherein the fiberglass braided sleeve comprises strands of fiberglass spirally braided in the longitudinal direction of the sleeve, and c) a working fluid (205) in the enclosed interior space of the tubular body. A schematic drawing of the heat pipe according to the present invention can be seen in Figure 2.

The inventive heat pipe efficiently transfers heat through a process of vaporization and condensation of a working fluid within the enclosed interior space. More precisely, the working fluid (205) is vaporized at the first closed end (202) that is in direct or indirect contact with a concentrated heat source and the vapor (206) flows through the transfer section (203) toward the second closed end (204) of the heat pipe. Thereby, heat is transferred by the heat pipe from the concentrated heat source to a colder zone that is at the second closed end of the heat pipe. Afterwards, the working fluid is transported (207) back to the first closed end (202) by the fiberglass braided sleeve (201).

The glass material of the inventive heat pipe provides non-conductive properties, making the design suitable for applications where electromagnetic interference from metal components is undesirable. Furthermore, the fiberglass braided sleeve provides especially capillary action, facilitating the return of the condensed working fluid to the first closed end of the heat pipe, thus maintaining the continuous cycle of vaporization and condensation. This innovative design offers a solution that is both effective in heat transfer and compatible with sensitive electronic environments, overcoming the limitations of existing heat pipe technologies. Another advantage is that the components can be used to adjust the heat pipe's performance very precisely.

In the following the details and preferred embodiments of the inventive heat pipe will be set out in more detail. It is to be understood that these technical details and embodiments also apply to the inventive method for producing the heat pipe as well as to the use of the inventive heat pipe.

### Glass tubular body

According to the present invention, the heat pipe comprises a glass tubular body comprising a first closed end, a second closed end and a transfer section, wherein the inner surface of the tubular body encloses an interior space. The glass tubular body is a fundamental component of the heat pipe, because it defines the outer and inner geometry of the heat pipe and also seals the interior space containing the fiberglass braided sleeve and the working fluid from the outside.

The glass tubular body comprises a first closed end, a second closed end a transfer section. This results in an enclosed interior space within the tubular body that serves as boundary for the working fluid, the fiberglass braided sleeve as well as the atmosphere of the enclosed interior space. The first and second closed end prevent any leakage of the working fluid and maintain the integrity of the sealed environment.

The "first closed end of the glass tubular body" in the meaning of the present invention might be seen as the "starting point" of the cooling cycle of the heat pipe, wherein the working fluid is vaporized. Afterwards the vaporized working fluid flows through the transfer section to the second closed end. The "transfer section" in the meaning of the present invention is the central part of the glass tubular body, where the majority of heat exchange occurs. It is designed to maximize the surface area available for heat transfer, facilitating the rapid vaporization and condensation of the working fluid. The technical effect of the transfer section is to enhance the thermal conductivity of the heat pipe, allowing it to efficiently transport heat from the source to the sink. Finally, the heat is transferred to the second closed end. The "second closed end of the glass tubular body" in the meaning of the present invention might be seen as the "end point" of the cooling cycle of the heat pipe, where the working fluid it is condensed and is recirculated back by the fiberglass braided sleeve.

It has to be noted that the first closed end, the transfer section and the second closed end are three theoretical areas of the tube, but they merge and are not always clearly distinguishable.

The design of the glass tubular body assesses considerations of the dimensions and proportions of the tubular body, including the geometry and its cross section, its length, diameter, and wall thickness as well as the material. These parameters are optimized to ensure that the heat pipe can deliver the required thermal performance while fitting within the physical constraints of the application.

The geometry of the transfer section of the glass tubular body can vary, potentially taking forms such as cylindrical, ellipsoidal, prismatic, for example triangular prismatic, cu-boidal, or other shapes. The skilled person will choose the geometry of the transfer section based on the intended use of the heat pipe.

According to a preferred embodiment of the present invention, the geometry of the transfer section of the glass tubular body is cylindrical or ellipsoidal and most preferably cylindrical. The inventors surprisingly found that the ellipsoidal and even more the cylindrical shape is ideal for maximizing the surface area available for heat transfer while maintaining a compact form factor. This maximization is crucial for efficient thermal management, as it allows for more effective heat exchange between the working fluid and the surrounding environment. Secondly, the ellipsoidal and the cylindrical geometry facilitates the even distribution of the working fluid within the tubular body. This even distribution is essential for maintaining consistent thermal performance across the entire length of the heat pipe, as it ensures that the working fluid can efficiently undergo cycles of vaporization and condensation without pooling or uneven flow. Additionally, the ellipsoidal and even more the cylindrical form provides structural advantages. It offers uniform strength and pressure resistance, which are important for maintaining the integrity of the vacuum-sealed or reduced pressure environment within the heat pipe. This uniformity helps prevent deformation or failure under the internal pressures generated during the heat transfer process. In Figure 3 a glass tubular body (200) with a cylindrical geometry is shown. The transfer section (203) as well as the first closed end (202) and second closed end (204) have all the same cylindrical geometry and the first closed end, and the second closed end of the glass tubular body are straight. Both ends are identical.

The profile of the transfer section of the glass tubular body can vary, potentially taking forms such as oval, round, triangular, rectangular, or other shapes. The skilled person will choose the profile of the transfer section based on the intended use of the heat pipe. The "profile" of the transfer section, also known as the "cross-section" in the meaning of the present invention is the obtained shape when cutting the transfer section of the glass tubular body with a plane at the point, wherein the plane meets the transfer section of the glass tubular body at a right angle.

According to a preferred embodiment of the present invention, the profile of the glass tubular body, preferably the profile of the transfer section of the glass tubular body has an oval or round profile and preferably has a round profile. The inventors surprisingly found that the oval and even more the round profile is ideal for maximizing the surface area available for heat transfer while maintaining a compact form factor. This maximization is crucial for efficient thermal management, as it allows for more effective heat exchange between the working fluid and the surrounding environment. Secondly, the oval and the round profile facilitates the even distribution of the working fluid within the tubular body. This even distribution is essential for maintaining consistent thermal performance across the entire length of the heat pipe, as it ensures that the working fluid can efficiently undergo cycles of vaporization and condensation without pooling or uneven flow. Additionally, the oval and even more the round profile provides structural advantages. It offers uniform strength and pressure resistance, which are important for maintaining the integrity of the vacuum-sealed or reduced pressure environment within the heat pipe. This uniformity helps prevent deformation or failure under the internal pressures generated during the heat transfer process.

The geometry of the first closed end and/or second closed end of the glass tubular body can vary, potentially taking forms such as rounded, curved, pointed or straight, or other shapes. The skilled person will choose the geometry of the first closed end and/or second closed end based on the intended use of the heat pipe and the equipment for closing both ends. According to a preferred embodiment the geometry of the first closed end and/or the second closed end is rounded or curved. Such a geometry is especially preferred since it improves the stability of the glass tubular body and, therefore, of the heat pipe and can thus help to reduce breakage.

The geometry of the first closed end can be identical with the geometry of the second closed and or can be different. According to a preferred embodiment the geometry of the first closed end and of the second closed end are identical.

The length of the glass tubular body, often referred to as the "length of the heat pipe", is one of the parameters that influences the heat pipe's performance. This length in the meaning of the present invention is defined as the distance from the first closed end to the second closed end of the glass tubular body within the glass tubular body. In case the first and second closed end are not straight but, for example, rounded or pointed, the length is measured from the widest point. In case the glass tubular body and especially the transfer section are not straight but, for example, curved or rounded, the distance is also measured in the same curving our rounding. In other words, the length is measured from the widest point of the first closed end to the widest point of the second closed end, wherein the measuring line can be curved or rounded but always lies within the glass tubular body. The length can be measured using standard measuring tools such as calipers or rulers, ensuring precision to accommodate the specific requirements of the application.

A longer glass tubular body provides a greater surface area for heat exchange, which enhances the efficiency of the vaporization and condensation cycle. This increased surface area allows for more effective heat transfer, as it provides more space for the working fluid to evaporate and condense, thereby improving the overall thermal management capabilities of the heat pipe. However, the length of the heat pipe must be carefully optimized to balance its heat transfer capabilities with the physical constraints of the application. For instance, in compact electronic devices, space is often limited, necessitating a shorter heat pipe that can fit within the device's dimensions without compromising its functionality. Conversely, in larger systems where space is less of a concern, a longer heat pipe may be utilized to maximize heat transfer efficiency.

The length of the heat pipe can vary widely. According to one embodiment the length of the glass tubular body is from 10 mm to 600 mm, preferably from 50 mm to 400 mm, even more preferably from 70 mm to 200 mm and most preferred from 80 mm to 120 mm. Within this range, specific lengths such as 75 mm, 100 mm, 150 mm, 200 mm, and 250 mm may be selected based on the particular application and the thermal management requirements. The choice of length is dependent on several factors, including the size of the device, the amount of heat that needs to be dissipated, and the available space for installation. A skilled person in the field of thermal management will choose the appropriate length of the heat pipe and the glass tubular body based on where it will be used. For example, in a compact laptop or a cell phone, a shorter heat pipe might be preferred to fit within the limited space, while in a larger desktop computer, a longer heat pipe could be used to enhance cooling efficiency. The decision will also take into account the specific thermal challenges of the application, ensuring that the heat pipe provides optimal performance without exceeding the physical constraints of the device. The inner and outer diameters of the glass tubular body, often referred to as the "inner and outer diameter of the heat pipe" are two further parameters that influence the heat pipe's performance. The inner diameter must be large enough to accommodate the fiberglass braided sleeve and the working fluid, while the outer diameter must be minimized to fit within the physical constraints of the application. The ratio of the inner to outer diameter is crucial for maintaining the structural integrity of the glass tubular body under vacuum or reduced pressure conditions.

The "inner diameter" in the meaning of the present invention is defined as the shortest distance across the interior space of the cross section of the glass tubular body, passing from one inner wall of the glass tubular body to another inner wall. In case the glass tubular body is cylindrical, and the cross section of the glass tubular body is round the "inner diameter" in the meaning of the present invention is the diameter of the interior space measured from one inner wall of the glass tubular body to another wall.

The inner diameter of the heat pipe can vary widely. According to one embodiment of the present invention, the inner diameter of the glass tubular body is from 0.5 mm to 300 mm. The size depends on the required performance of the heat pipe and the available space for the heat pipe. For example, the inner diameter of the glass tubular body is from 0.6 mm to 10 mm, preferably from 0.7 mm to 1 mm and most preferably about 0.8 mm. Alternatively the inner diameter of the glass tubular body is from 1 mm to 250 mm, preferably from 5 mm to 200 mm, even more preferably from 7 mm to 100 mm and most preferably from 10 mm to 50 m. Within this range, specific inner diameters such as 0.8 mm, 1 mm, 5 mm, 10 mm, 15 mm, 20 mm, and 25 mm, may be chosen based on the particular application and the thermal management requirements.

The outer diameter of the heat pipe can vary widely. According to one embodiment of the present invention, the outer diameter of the glass tubular body is from 0.55 mm to 350 mm. The size depends on the required performance of the heat pipe and the available space for the heat pipe. For example, the outer diameter of the glass tubular body is from 0.65 mm to 11 mm, preferably from 0.75 mm to 2 mm and most preferably about 0.9 mm. Alternatively the outer diameter of the glass tubular body is from 2 mm to 250 mm, preferably from 7 mm to 250 mm, even more preferably from 10 mm to 150 mm and most preferably from 12 mm to 60 mm. Within this range, specific outer diameters such as 1 mm, 5 mm, 7 mm, 12 mm, 20 mm, 25 mm, and 30 mm, may be chosen based on the particular application and the thermal management requirements.

The width of the glass tubular body is another parameter that influences the heat pipe's performance. The "width of the glass tubular body" sometimes referred to as the "wall thickness" in the meaning of the present invention is defined as the difference between the outer and inner diameter of the glass tubular body, measured at the transfer section. The width of the heat pipe can vary widely. According to one embodiment of the present invention, the width of the glass tubular body is from 0.05 mm to 30 mm, preferably from 0.1 mm to 20 mm, even more preferably from 0.3 mm to 15 mm and most preferably from 0.5 mm to 10 m. Within this range, specific widths such as 0.5 mm, 0.8 mm, 1.5 mm, 1.8 mm, and 2.5 mm, may be chosen based on the particular application and the thermal management requirements. The choice of width is dependent on several factors, including the size of the device, the amount of heat that needs to be dissipated, and the available space for installation. A skilled person in the field of thermal management will choose the appropriate width of the heat pipe and the glass tubular body based on where it will be used. A thicker wall provides greater structural integrity and resistance to breakage, which is crucial for maintaining the vacuum-sealed or pressure reduced environment. However, a thicker wall also reduces the heat transfer efficiency, as it increases the thermal resistance. Conversely, a thinner wall enhances heat transfer by allowing more rapid evaporation and condensation of the working fluid, but it may compromise the heat pipe's mechanical strength and make it more susceptible to breakage. The skilled person will find a balance between these factors, optimizing the inner and outer diameters, as well as the wall thickness, to achieve the desired thermal performance while ensuring the structural integrity and durability of the heat pipe. This balance is crucial for the heat pipe to function effectively in its intended application, whether in compact electronic devices or larger systems requiring efficient thermal management. Furthermore, the ratio of the inner diameter of the glass tubular body to the length of the glass tubular body has to be carefully balanced in order to obtain an optimized working cycle of evaporation and recondensation within the glass tubular body and thereby an optimized thermal management of the heat pipe. The inventors surprisingly found that an optimized thermal management is possible when the glass tubular body has a ratio of diameter to length from 1:2.0 to 1:100, preferably from 1:2.5 to 1:80, more preferably from 1:5 to 1:60.

According to another preferred embodiment the glass tubular body has a ratio of diameter to length from 1:2.0 to 1:100, preferably from 1:2.5 to 1:80, more preferably from 1:5 to 1:60 and has an oval or round profile and preferably has a round profile.

The glass tubular body is designed to achieve an optimal balance between structural integrity and thermal efficiency, which are paramount for the effective operation of the heat pipe. This design must ensure that the tubular body is robust enough to withstand the internal pressures generated during the vaporization and condensation cycles of the working fluid. Such pressures can be significant, especially in high-performance applications, necessitating a design that can maintain its structural integrity under these conditions.

According to one embodiment of the present invention, the design of the glass tubular body must maintain a vacuum-sealed environment or at least a pressure of below 100 Pa, preferably below 1.0 Pa, more preferably below 0.1 Pa, even more preferably below 1*10⁻⁶ Pa and even more preferably below 1*10⁻⁹ Pa. This vacuum or reduced pressure is essential for reducing the boiling point of the working fluid, thereby enhancing the efficiency of the heat transfer process. The vacuum seal must be meticulously maintained to prevent any ingress of air or other gases, which could compromise the heat pipe's performance.

To achieve this robustness, the glass tubular body is typically constructed from materials known for their mechanical strength, thermal stability and ability to maintain a vacuum-sealed or reduced pressure environment, such as soda-lime glass, borosilicate or aluminosilicate glass. These materials are chosen not only for their ability to withstand pressure but also for their resistance to thermal shock, which is crucial in applications where rapid temperature changes are common.

According to a preferred embodiment of the present invention, the glass of the glass tubular body may be selected from the group consisting of soda-lime glass, borosilicate glass, alkaline-resistant glass and aluminosilicate glass. Optionally, a borosilicate glass is used.

The glass of the glass tubular body preferably comprises the following components in the indicated amounts (in wt.%):

| **Component** | **Content (wt.%)** |
|---|---|
| SiO₂ | 40 to 85 |
| Al₂O₃ | 0 to 25 |
| Na₂O | 0 to 18 |
| K₂O | 0 to 15 |
| MgO | 0 to 10 |
| B₂O₃ | 0 to 22 |
| Li₂O | 0 to 10 |
| ZnO | 0 to 5 |
| CaO | 0 to 16 |
| BaO | 0 to 12 |
| ZrO₂ | 0 to 5 |
| CeO₂ | 0 to 0.5 |
| SnO₂ | 0 to 3 |
| P₂O₅ | 0 to 15 |
| Fe₂O₃ | 0 to 1.5 |
| TiO₂ | 0 to 10 |
| SrO | 0 to 1 |
| F | 0 to 1 |
| CI | 0 to 1 |

SiO₂ is a relevant network former that can be used in the glass used for this of the invention. Therefore, the glasses may comprise SiO₂ in an amount of at least 60 wt.%. More preferably, the glass comprises SiO₂ in an amount of at least 62 wt.%, at least 65 wt.%, at least 68 wt.%, more than 70 wt.%, or even more than 75 wt.%. However, the content of SiO₂ in the glass should also not be extremely high because otherwise the meltability may be compromised. The amount of SiO₂ in the glass may be limited to at most 85 wt.%, or at most 82 wt.%. In embodiments, the content of SiO₂ in the glass is from 60 to 85 wt.%, or from >65 to 75 wt.%.

B₂O₃ may be used in order to enhance the network by increasing the bridge-oxide in the glass via the form of [BO₄] tetrahedra. It also helps to improve the damage resistance of the glass. However, B₂O₃ should not be used in high amounts in the glass since it can decrease the ion-exchange performance. Furthermore, the addition of B₂O₃ can significantly reduce the Young's modulus. The glass may comprise B₂O₃ in an amount of from 0 to 20 wt.%, preferably from 0 to 15 wt.%, preferably from 0.1 to 13 wt.%. In embodiments, the glass preferably comprises at least 5 wt.%, more preferably at least 7 wt.%, or at least 10 wt.% of B₂O₃.

P₂O₅ may be used in the glass of the invention in order to help lowering the melting viscosity by forming [PO₄] tetrahedra, which can significantly lower the melting point without sacrificing anti-crystallization features. Limited amounts of P₂O₅ do not increase geometry variation very much, but can significantly improve the glass melting, forming performance, and ion-exchanging (chemical toughening) performance. However, if high amounts of P₂O₅ are used, geometry expansion upon chemical toughening may be increased significantly. Therefore, the glasses may comprise P₂O₅ in an amount of from 0 to 4 wt.%, or from 0 to 2 wt.%. In some embodiments, the glass is free of P₂O₅.

It is believed that Al₂O₃ can easily form tetrahedra coordination when the alkaline oxide ratio content is equal or higher than that of Al₂O₃. [AlO₄] tetrahedra coordination can help building up more compact network together with [SiO₄] tetrahedra, which can result in a low geometry variation of the glass. [AlO₄] tetrahedra can also dramatically enhance the ion-exchange process during chemical toughening. Therefore, Al₂O₃ is preferably contained in the glasses in an amount of at least 0 wt.%, more preferably of more than 1 wt.%, more preferably of more than 4 wt.%. However, the amount of Al₂O₃ should also not be very high because otherwise the viscosity may be very high so that the meltability may be impaired. Therefore, the content of Al₂O₃ in the glasses is preferably at most 20 wt.%, at most 12 wt.%, or at most 10 wt.%. In preferred embodiments, the content of Al₂O₃ in the glasses is from 0 to 20 wt.%, from 1 to 12 wt.%, from 4 to 10 wt.%.

TiO₂ can also form [TiO₄] and can thus help building up the network of the glass, and may also be beneficial for improving the acid resistance of the glass. However, the amount of TiO₂ in the glass should not be very high. TiO₂ present in high concentrations may function as a nucleating agent and may thus result in crystallization during manufacturing. Preferably, the content of TiO₂ in the glasses is from 0 to 10 wt.%, or up to 7 wt.%. In some embodiments, the glass comprises at least 0.5 wt.%, at least 2 wt.%, or at least 3 wt.% of TiO₂. In an embodiment, the glass is free of TiO₂.

ZrO₂ has the functions of lowering the CTE and improving the alkaline resistance of a glass. It may increase the melting viscosity, which can be suppressed by using P₂O₅. Like alkaline metals, Zr⁴⁺ is also a network modifier. Furthermore, ZrO₂ is a significant contributor for increased Young's modulus. Preferably, the content of ZrO₂ in the glasses is from 0 to 5 wt.%, up to 2 wt.%. The glass may be free of ZrO₂. In some embodiments, the glass comprises at least 0.1 wt.%, or at least 0.2 wt.% ZrO₂.

Alkaline oxides R₂O (Li₂O + Na₂O + K₂O + Cs₂O) may be used as network modifiers to supply sufficient oxygen anions to form the glass network. Preferably, the content of R₂O in the glasses is more than 4 wt.%, or more than 12 wt.%. However, the content of R₂O in the glass should not be very high because otherwise chemical stability and chemical toughenability may be impaired. Preferably, the glasses comprise R₂O in an amount of at most 30 wt.%, at most 25 wt.%, or at most 20 wt.%. Other embodiments are free of alkaline oxides, or at least free of Na₂O, K₂O, Cs₂O and/or Li₂O

Li₂O can help improving the Young's modulus and lowering CTE of the glass. Li₂O also influences the ion-exchange greatly. It was surprisingly found that Li-containing glass has a smaller geometry variation. Therefore, the content of Li₂O in the glasses may be set to at least 0 wt.%, or more than 5 wt.%, or even more than 10 wt.%. However, the content of Li₂O should not be very high because otherwise chemical stability and chemical toughenability may be impaired. Preferably, the content of Li₂O in the glasses is at most 24 wt.%, less than 15 wt.%, or even 0 wt.%.

Na₂O may be used as a network modifier. However, the content of Na₂O should not be very high because otherwise chemical stability and chemical toughenability may be impaired. Preferably, the content of Na₂O in the glasses is from 0 to 15 wt.%, preferably from 2 to 15 wt.%. In preferred embodiments, the content of Na₂O in the glasses is at least 5 wt.%, at least 8 wt.%, or at least 10 wt.%.

K₂O may be used as a network modifier. However, the content of K₂O should not be very high because otherwise chemical stability and chemical toughenability may be impaired. Preferably, the content of K₂O in the glasses is from 0 to 15 wt.%, or from >0.5 to 7 wt.%. The glass may be free of K₂O.

Preferably, the glasses comprise more Na₂O than K₂O. Thus, preferably the molar ratio Na₂O/(Na₂O+K₂O) is from >0.5 to 1.0, from >0.6 to 1.0, from >0.7 to 1.0, or from >0.8 to 1.0.

Preferably, the content of the sum of Li₂O and Na₂O in the glasses is more than 10 mol-%, or more than 15 mol-%. However, the content of the sum of Li₂O and Na₂O in the glasses should not be very high. Preferably, the content of the sum of Li₂O and Na₂O in the glasses is at most 25 mol-%, or at most 20 mol-%.

The glasses may also comprise alkaline earth metal oxides as well as ZnO which are collectively termed "RO" in the present specification. Alkaline earth metals and Zn may serve as network modifiers. Preferably, the glasses comprise RO in an amount of from 0 to 20 wt.%, preferably from 0 to 15 wt.%. In some embodiments, the glass preferably comprises at least 0.5 wt.%, more preferably at least 1 wt.%, more preferably at least 5 wt.% of RO. Preferred alkaline earth metal oxides are selected from the group consisting of MgO, CaO, SrO und BaO. More preferably, alkaline earth metals are selected from the group consisting of MgO und CaO. More preferably, the alkaline earth metal is MgO. Preferably, the glass comprises MgO in an amount of from 0 to 10 wt.%. In some embodiments, the glass comprises at least 0.5 wt.%, at least 1 wt.%, or at least 2 wt.% of MgO. Preferably, the glass comprises CaO in an amount of from 0 to 16 wt.%, preferably from 0 to 13 wt.%, preferably from 0 to 10 wt.%. In some embodiments, the glass comprises at least 0.5 wt.%, at least 1 wt.%, at least 5 wt.%, at least 10 wt.%, or at least 12 wt.% of CaO. Preferably, the glass comprises BaO in an amount of from 0 to 12 wt.%, preferably from 0 to 10 wt.%. In some embodiments, the glass comprises at least 0.5 wt.%, at least 2 wt.%, or at least 7 wt.% of BaO. The glass may be free of BaO, MgO and/or CaO.

Preferably, the glass comprises ZnO in an amount of from 0 to 5 wt.%. In some embodiments, the glass comprises at least 0.5 wt.%, at least 1 wt.%, or at least 2 wt.% of ZnO. In other embodiments, the glass is free of ZnO. Preferably, the content of the sum of MgO and ZnO in the glasses is from 0 to 10 wt.%. In some embodiments, the content of the sum of MgO and ZnO in the glasses at least 0.5 wt.%, more preferably at least 1 wt.%, more preferably at least 2 wt.%.

At the end, when forming a glass by mixing different types of the oxides, the integrated effect should be considered to achieve a glass with comparatively low expansion, which is supported by high densification of the glass network. It means, in addition to [SiO₄] tetrahedral [BO₄] tetrahedra, [AlO₄] tetrahedra, or [PO₄] tetrahedra are expected to help connect the [SiO₄] more effectively rather than other types of polyhedrons. In other words, [BO₃] triangle and [AlO₆] octahedron, for instance, are not preferred. It means, sufficient oxygen anions are preferable to be offered by adding proper amounts of metal oxides, such as R₂O and RO.

Preferably, the content of SnO₂ in the glasses is from 0 to 3 wt.%. More preferably, the glasses are free of SnO₂. Preferably, the content of Sb₂O₃ in the glasses is from 0 to 3 wt.%. More preferably, the glasses are free of Sb₂O₃. Preferably, the content of CeO₂ in the glasses is from 0 to 3 wt.%. High contents of CeO₂ are disadvantages because CeO₂ has a coloring effect. Therefore, more preferably, the glasses are free of CeO₂. Preferably, the content of Fe₂O₃ in the glasses is from 0 to 3 wt.%. More preferably, the glasses are free of Fe₂O₃.

The glass described herein is described as having a composition of different constituents. This means that the glass contains these constituents without excluding further constituents that are not mentioned. However, in preferred embodiments, the glass consists of the components mentioned in the present specification to an extent of at least 95%, more preferably at least 97%, most preferably at least 99%. In most preferred embodiments, the glass essentially consists of the components mentioned in the present specification.

Optionally, coloring oxides can be added, such as Nd₂O₃, Fe₂O₃, CoO, NiO, V₂O₅, MnO₂, CuO, CeO₂, Cr₂O₃.

0-2 wt.% of As₂O₃, Sb₂O₃, SnO₂, SO₃, Cl and/or F could be also added as refining agents. 0-5 wt.% of rare earth oxides could also be added to add optical or other functions to the glass wall.

The terms "*X-free*" and "*free of component X"*, or "0 % of X", respectively, as used herein, refer to a glass, which essentially does not comprise said component X, i.e. such component may be present in the glass at most as an impurity or contamination, however, is not added to the glass composition as an individual component. This means that the component X is not added in essential amounts. Non-essential amounts according to the present invention are amounts of less than 100 ppm, preferably less than 50 ppm and more preferably less than 10 ppm. Preferably, the glasses described herein do essentially not contain any components that are not mentioned in this description.

In embodiments, the glass used for the glass tube element has the following composition in percent by weight:

| **Component** | **Content (wt.%)** |
|---|---|
| SiO₂ | 40 to 85 |
| Al₂O₃ | 0 to 25 |
| Na₂O | 2 to 18 |
| K₂O | 0 to 15 |
| MgO | 0 to 10 |
| B₂O₃ | 0 to 15 |
| Li₂O | 0 to 10 |
| ZnO | 0 to 5 |
| CaO | 0 to 10 |
| BaO | 0 to 5 |
| ZrO₂ | 0 to 5 |
| CeO₂ | 0 to 0.5 |
| SnO₂ | 0 to 3 |
| P₂O₅ | 0 to 15 |
| Fe₂O₃ | 0 to 1.5 |
| TiO₂ | 0 to 10 |
| SrO | 0 to 1 |
| F | 0 to 1 |
| CI | 0 to 1 |

In embodiments, the glass used for the glass tubular body has the following composition in percent by weight:

| **Component** | **Content (wt.%)** |
|---|---|
| SiO₂ | 55 to 65 |
| Al₂O₃ | 10 to 20 |
| Na₂O | 0 to 3 |
| K₂O | 0 to 3 |
| MgO | 0 to 5 |
| B₂O₃ | 0 to 6 |
| Li₂O | 0 to 3 |
| ZnO | 0 to 3 |
| CaO | 7 to 15 |
| BaO | 5 to 10 |
| ZrO₂ | 0 to 3 |
| CeO₂ | 0 to 0.5 |
| SnO₂ | 0 to 3 |
| P₂O₅ | 0 to 3 |
| Fe₂O₃ | 0 to 1.5 |
| TiO₂ | 0 to 3 |
| SrO | 0 to 1 |
| F | 0 to 1 |
| CI | 0 to 1 |

In embodiments, the glass used for the glass tubular body has the following composition in percent by weight:

| **Component** | **Content (wt.%)** |
|---|---|
| SiO₂ | 65 to 85 |
| Al₂O₃ | 0 to 7 |
| Na₂O | 0.5 to 10 |
| K₂O | 0 to 10 |
| MgO | 0 to 3 |
| B₂O₃ | 8 to 20 |
| Li₂O | 0 to 3 |
| ZnO | 0 to 3 |
| CaO | 0 to 3 |
| BaO | 0 to 3 |
| ZrO₂ | 0 to 3 |
| CeO₂ | 0 to 0.5 |
| SnO₂ | 0 to 3 |
| P₂O₅ | 0 to 3 |
| Fe₂O₃ | 0 to 1.5 |
| TiO₂ | 0 to 3 |
| SrO | 0 to 1 |
| F | 0 to 1 |
| CI | 0 to 1 |

In embodiments, the glass used for the glass tubular body has the following composition in percent by weight:

| **Component** | **Content (wt.%)** |
|---|---|
| SiO₂ | 60 to 80 |
| Al₂O₃ | 0 to 5 |
| Na₂O | 10 to 18 |
| K₂O | 0 to 5 |
| MgO | 0 to 5 |
| B₂O₃ | 0 to 5 |
| Li₂O | 0 to 3 |
| ZnO | 0 to 3 |
| CaO | 2 to 10 |
| BaO | 0 to 5 |
| ZrO₂ | 0 to 3 |
| CeO₂ | 0 to 0.5 |
| SnO₂ | 0 to 3 |
| P₂O₅ | 0 to 3 |
| Fe₂O₃ | 0 to 1.5 |
| TiO₂ | 0 to 3 |
| SrO | 0 to 1 |
| F | 0 to 1 |
| CI | 0 to 1 |

According to an exemplified embodiment of the present invention the glass tubular body has a length of 120 mm and an outer diameter of 1.5 mm as well as a wall thickness of 0.08 mm. The glass tubular body preferably has a round profile, and the closed ends are curved. Preferably the glass used for the glass tubular body has the following composition in percent by weight:

| **Component** | **Content (wt.%)** |
|---|---|
| SiO₂ | 60 to 80 |
| Al₂O₃ | 2 to 7 |
| Na₂O | 5 to 10 |
| K₂O | 0 to 5 |
| MgO | 0 to 5 |
| B₂O₃ | 3 to 15 |
| Li₂O | 0 to 3 |
| ZnO | 0 to 3 |
| CaO | 2 to 10 |
| BaO | 0 to 5 |
| ZrO₂ | 0 to 3 |
| CeO₂ | 0 to 0.5 |
| SnO₂ | 0 to 3 |
| P₂O₅ | 0 to 3 |
| Fe₂O₃ | 0 to 1.5 |
| TiO₂ | 0 to 3 |
| SrO | 0 to 1 |
| F | 0 to 1 |
| CI | 0 to 1 |

The glass of the glass tubular body and/or the glass tubular body might additionally be strengthened, especially chemically strengthened, in order to provide glasses or glass tubes with higher mechanical resistance. For this purpose, the glass, especially aluminosilicate glasses with high sodium content, might be subjected to an ion exchange to form a compressive stress layer that prevents mechanical damage and is therefore much more resistant to damage. This is especially advantageous for glass tubes that are used in heat pipes that are used in portable devices or handheld devices. The ion exchange process works in such a way that, at the glass surface, smaller alkali metal ions, such as for instance sodium and/or lithium ions, are exchanged for larger alkali metal ions, such as potassium ions. The duration and temperature of the ion exchange process determines the exchange layer depth. If this ion exchange depth exceeds the depth of damage to the surface of the product during use, breakage is prevented. Chemical strengthening under ion exchange is carried out, for example, by immersion in a potassium-containing salt melt. It is also possible to use an aqueous potassium silicate solution, paste or dispersion, or to perform ion exchange by vapor deposition or temperature-activated diffusion. The first of the above-named methods is generally preferred. The skilled person knows such strengthening processes, for example, from EP 3819269.

### Fiberglass braided Sleeve

The heat pipe according to the present invention comprises a fiberglass braided sleeve within the enclosed interior space of the tubular body. The fiberglass braided sleeve

comprises strands of fiberglass spirally braided in the longitudinal direction of the sleeve. A "fiberglass braided sleeve" in the meaning of the present invention is a sleeve or hose made form braided fiberglass strands that comprise fiberglass fibers. Its construction involves braiding these strands into a tubular form, creating a sleeve that is flexible yet durable. Due to the braiding pattern the sleeve can expand and contract to accommodate irregular shapes and sizes. The braiding process ensures uniformity and strength throughout the sleeve.

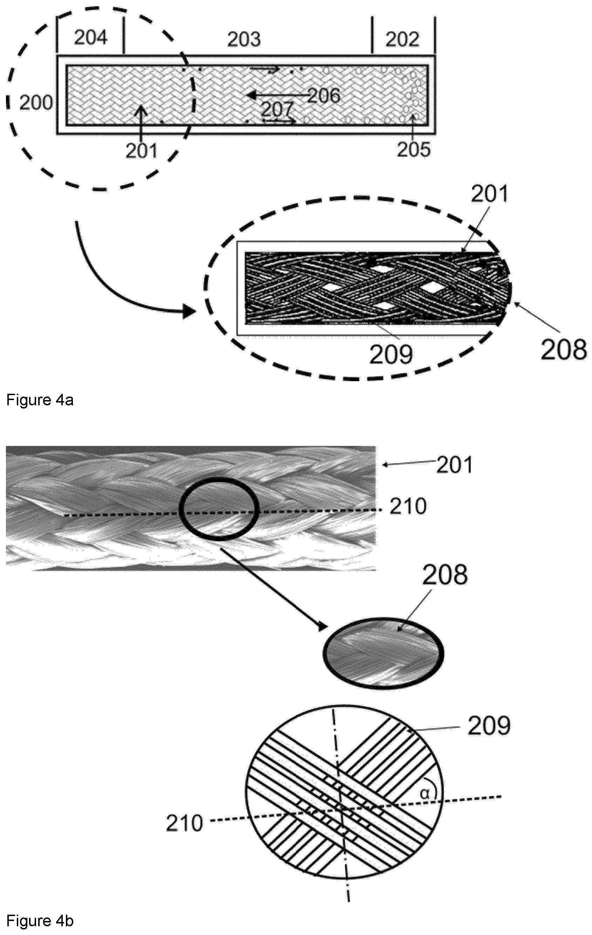

Figures 4a and 4b show a schematic drawing of the fiberglass braided sleeve according to the present invention. Figure 4a shows the schematic drawing of the fiberglass braided sleeve within the glass tubular body. The fiberglass braided sleeve (201) is spirally braided in the form of a sleeve or hose inside the glass tubular body (200). From Figures 4a and 4b it can be seen that the fiberglass braided sleeve (201) comprises strands of fiberglass (208) that are spirally braided along the braiding axis (210). The strands of fiberglass comprise bundles of individual fibers (209).

The fiberglass braided sleeve can be characterized by the braiding angle, the number of fibers present in a strand and the diameter of the fibers, the diameter of the fiberglass braided sleeve as well as the material of these fibers.

The "braiding angle" in the meaning of the present invention is shown in Figure 4b and is measured in the natural state of the fiberglass braided sleeve, which means that the fiberglass braided sleeve is not stretched or compressed during the measurement of the braiding angle. The braiding angle α gives the orientation of the yarns in the plane of the braided sleeve and is defined as the angle between the yarn and a projection of the braiding axis (210) on the surface of the fiberglass braided sleeve. The skilled person will choose the braiding angle based on the intended use and the desired characteristics of the fiberglass braided sleeve. The fiberglass braided sleeve in the meaning of the present invention has preferably a braiding angle between 30° to 80°, more preferably between 40° to 60° and most preferably between 42° to 50°.

The strands of the fiberglass braided sleeve comprise bundles of fibers. A "fiber" in the meaning of the present invention is a thin rod of glass that is flexible and bendable. The skilled person will choose the number of fibers, and the diameter of the fibers based on the intended use and the desired characteristics of the fiberglass braided sleeve. According to a preferred embodiment, the strand of fibers comprises at least 50 fibers, more preferably at least 100 fibers, even more preferably at least 200 fibers and most preferably at least 300 fibers. According to another embodiment, the strand of fibers comprises less than 1000 fibers, more preferably less than 800 fibers and most preferably less than 500 fibers. According to another preferred embodiment, the strand of fibers comprises between 50 to 1000 fibers, more preferably between 100 to 800 fibers and most preferably between 200 to 500 fibers.

According to another embodiment of the present invention, the fibers have a diameter of 1 µm to 20 µm, preferably 2 µm to 15 µm and most preferably 3 µm to 10 µm. It is especially preferred that the fibers have a diameter of at least 3 µm, since evidence suggests that fibers below 3µm are respirable and possibly carcinogenic. The fibers may all have the same diameter or may have different diameters. According to a preferred embodiment the diameters have all the same diameter.

According to another embodiment of the present invention the strand of fibers comprises at least 50 fibers, more preferably at least 100 fibers and most preferably at least 200 fibers and the fibers have a diameter of 1 µm to 20 µm, preferably 2 µm to 15 µm and most preferably 3 µm to 10 µm.

According to another preferred embodiment of the present invention, the strand of fibers comprises between 50 to 1000 fibers, more preferably between 100 to 800 fibers and most preferably between 200 to 500 fibers and the fibers have a diameter of 1 µm to 20 µm, preferably 2 µm to 15 µm and most preferably 3 µm to 10 µm.

The "diameter of the fiberglass braided sleeve" in the meaning of the present invention is defined as the shortest distance across the interior space of the cross section of the fiberglass braided sleeve. In case the cross section of the fiberglass braided sleeve is round the "diameter" in the meaning of the present invention is the diameter of the interior space measured from one inner wall of the glass tubular body to another wall.

The diameter of the fiberglass braided sleeve can vary widely but is typically tailored to fit within the glass tubular body. The diameter can vary depending on the specific application, but it generally matches the inner diameter of the glass tubular body, ranging typically from 0.5 mm to 350 mm. According to a preferred embodiment, the diameter of the fiberglass braided sleeve from 90 to 150 % of the inner diameter of the glass tubular body, preferably 100 to 140%, even more preferably 105 to 130% and most preferably 110 to 120%. It is especially preferred that the diameter of the fiberglass braided sleeve is bigger than the inner diameter of the glass tubular body in order to ensure that the sleeve is pressed to the inside of the glass tubular body.

To achieve robustness and a good capillary force, the fiberglass braided sleeve is typically constructed from materials known for their mechanical strength, thermal stability and ability to maintain a vacuum-sealed or reduced pressure environment, as well as from materials that are chemically inert, such as soda-lime glass, borosilicate or aluminosilicate glass. These materials are chosen not only for their ability to withstand pressure but also for their resistance to thermal shock, which is crucial in applications where rapid temperature changes are common.

According to a preferred embodiment of the present invention, the glass of the fiberglass braided sleeve may be selected from the group consisting of soda-lime glass, borosilicate glass, alkaline-resistant glass and aluminosilicate glass. Optionally, an E-glass, a R-glass, a D-glass, T-glass or S-glass is used. Such glasses are known to the skilled person and commercially used for producing fiberglass braided sleeves.

The glass of the fiberglass braided sleeve can be chosen from the same glass composition as for the glass tubular body or a different glass composition. Preferably the glass of the fiberglass braided sleeve comprises the following components in the indicated amounts (in wt.%):

| **Component** | **Content (wt.%)** |
|---|---|
| SiO₂ | 40 to 85 |
| Al₂O₃ | 0 to 26 |
| Na₂O | 0 to 18 |
| K₂O | 0 to 15 |
| MgO | 0 to 10 |
| B₂O₃ | 0 to 23 |
| Li₂O | 0 to 10 |
| ZnO | 0 to 5 |
| CaO | 0 to 16 |
| BaO | 0 to 12 |
| ZrO₂ | 0 to 5 |
| CeO₂ | 0 to 0.5 |
| SnO₂ | 0 to 3 |
| P₂O₅ | 0 to 15 |
| Fe₂O₃ | 0 to 1.5 |
| TiO₂ | 0 to 10 |
| SrO | 0 to 1 |
| F | 0 to 1 |
| CI | 0 to 1 |

Further details have already been provided for the glass tubular body and also apply to the fiberglass braided sleeve. According to one embodiment the glass of the fiberglass braided sleeve and the glass tubular body are identical. According to another embodiment of the present invention, the glass of the fiberglass braided sleeve and the glass tubular body are different.

According to a preferred embodiment of the present invention, the glass of the fiberglass braided sleeve comprises the following components in the indicated amounts (in wt.%):

| **Component** | **Content (wt.%)** |
|---|---|
| SiO₂ | 50 to 65 |
| Al₂O₃ | 10 to 26 |
| CaO + MgO | 15 to 30 |
| R₂O | 0 to 5 |
| B₂O₃ | 4 to 10 |
| Li₂O | 0 to 10 |
| ZnO | 0 to 5 |

Such fiberglass braided sleeves are known to the skilled person and commercially available, for example from Culimeta or thoenes or Delock.

According to a preferred embodiment such sleeves are self-stabilizing. A "self-stabilizing fiberglass braided sleeve" in the meaning of the present invention is a fiberglass braided sleeve that retains its shape, particularly the diameter of the fiberglass braided sleeve under normal conditions and does not collapse in itself.

The self-stabilization is either obtained by the braiding pattern, the number of fibers in a strand and/or the material and geometry of the fiberglass braided sleeve or by a supporting thread that is present in one or more strands of the fiberglass braided sleeve. The supporting thread(s) might/may add further stabilization to the fiberglass braided sleeve. The supporting thread can be a metal wire, for example a copper wire or a polymer thread such as a nylon or PEEK thread. According to a preferred embodiment of the present invention, the fiberglass braided sleeve does not comprise a supporting thread and merely consists of fibers of fiberglass.

The fiberglass braided sleeve is present in the glass tubular body and preferably the fiberglass braided sleeve covers the inner surface of the tubular body. According to a preferred embodiment at least 40 % of the inner surface of the transfer section are covered with the fiberglass braided sleeve, more preferably at least 60 %, and most preferably at least 80 %, of the inner surface of the transfer section are covered with the fiberglass braided sleeve. According to another embodiment of the present invention at least 40 % of the inner surface of the glass tubular body are covered with the fiberglass braided sleeve, more preferably at least 60 %, and most preferably at least 80 %, of the inner surface of the glass tubular body are covered with the fiberglass braided sleeve. "Covered" in this context means that the fiberglass braided sleeve coats the inner surface of the glass tubular body. This refers to the entire area covered by the fiberglass braided sleeve, based on the total surface of the fiberglass braided sleeve. It should be noted that this is not the actual contact area, which can be significantly smaller, as the surface of the fiberglass braided sleeve is not flat due to the individual fibers and therefore the fiberglass braided sleeve does not lie completely flat on the surface of the glass tubular body. Rather it is possible that there is a small gap between parts of the surface of the fiberglass braided sleeve and the glass tubular body. In these parts, the capillary force which is known as the "flow" is generated.

The fiberglass braided sleeve is typically tailored to fit within the glass tubular body. Preferably, it extends from the first closed end to the second closed end, ensuring that the entire length of the heat pipe benefits from the capillary action. The length can vary depending on the specific application, but it generally matches the length of the glass tubular body, ranging typically from 10 mm to 600 mm, preferably from 50 mm to 400 mm, even more preferably from 70 mm to 200 mm and most preferred from 80 mm to 120 mm. Within this range, specific lengths such as 75 mm, 100 mm, 150 mm, 200 mm, and 250 mm may be selected based on the particular application and the thermal management requirements. According to a preferred embodiment, the length of the fiberglass braided sleeve from 10 to 99 % of the length of the glass tubular body, preferably 30 to 98%, even more preferably 50 to 95% and most preferably 75 to 92%.

Especially the fiberglass braided sleeve provides superior capillary action compared to conventional wicks or structures used in heat pipes.

The spirally braided structure of the fiberglass sleeve ensures efficient fluid movement, facilitating the return of the condensed working fluid to the evaporation section. This effective fluid movement is due to the capillary force of the fiberglass braided sleeve. The capillary force consist of two force components, namely the "flow" and the "torque". The "flow" in the meaning of the present invention is the force between the fiberglass braided sleeve and the wall of the glass tubular body. The "torque" in the meaning of the present invention is the force that is present within the fiberglass braided sleeve itself due to the braiding of the fiberglass braided sleeve and is not affected by the interior space of the fiberglass braided sleeve. The inventors surprisingly found that this torque is advantageous since it adds a further component to the capillary force of the fiberglass braided sleeve and the heat pipe. By this torque an improved recirculation process of the working fluid is possible, resulting in an improved overall efficiency of the inventive heat pipe by maintaining a continuous cycle of vaporization and condensation. This torque is particularly beneficial in applications where the heat pipe must operate in various orientations or under conditions where gravity-assisted return is not feasible. However, the heat pipes known in the prior art mainly comprise rolled-up fiber mats or meshes or fiber fabrics, but these products do not comprise this torque and, therefore, the recirculation of the working fluid is mainly based on the flow, namely the force between the fiberglass braided sleeve and the wall of the glass tubular body.

According to one embodiment of the present invention, the fiberglass braided sleeve has a torque of at least 0.1 cm/min, preferably at least 0.2 cm/min, more preferably at least 0.3 cm/min even more preferably 0.4 cm/min and most preferably 0.5 cm/min. Additionally or alternatively, the fiberglass braided sleeve has a maximal torque of at least 5 cm, preferably at least 10 cm, even more preferably at least 15 cm and most preferably at least 20 cm.

The torque and the maximal torque of the fiberglass braided sleeve can be measured by providing a fiberglass braided sleeve with a length of 50 cm. This fiberglass braided sleeve is hung up at the upper end and hangs down freely. At the lower end the fiberglass braided sleeve hangs freely in a beaker filled with 100 ml distilled water. The fiberglass braided sleeve immerses into the distilled water for 5 cm. The water has a temperature of 20 °C (293.15 K, 68 °F) and the measurement is done under normal conditions. When inserting the fiberglass braided sleeve in the water the water rises up in the fiberglass braided sleeve. The rise of the water column in the fiberglass braided sleeve is initially a linear growth, which is limited and approaches a maximum value over time. The initial linear growth is measured in cm/min and is referred to as the "torque". The maximum value of the limited growth is referred to as the "maximal torque". The values can be determined by observation and measurement with a clock and ruler. For better visibility, the distilled water can be colored.

### Working Fluid

The heat pipe comprises a working fluid in the enclosed interior space of the tubular body.

The working fluid is a key element in the heat transfer process, undergoing cycles of vaporization and condensation to transport heat from the first closed end of the glass tubular body to the second closed end. The selection of an appropriate working fluid is dependent on the operating temperature range and specific application requirements, ensuring optimal performance and efficiency. The skilled person knows such working fluids and how to choose a working fluid for a defined application.

According to one embodiment of the present invention, the working fluid is selected from water, alcohols, ketones, fluorocarbons and mixtures thereof. Preferably, the working fluid is selected from water, ethanol, methanol, perfluorocarbons and mixtures thereof. According to a most preferred embodiment, the working fluid is water.

"Water" in the meaning of the present invention is an inorganic compound with the chemical formula H₂O and is a transparent, odorless, and non-toxic chemical substance. Water is the most preferred working fluid due to its high latent heat of vaporization and wide availability. It is particularly effective in applications with moderate temperature ranges, typically between 0°C and 100°C. The advantages of using water include its non-toxic nature, low cost, and excellent thermal properties. However, its use is limited in applications requiring operation at temperatures below freezing or above boiling without pressurization. According to a preferred embodiment the water is demineralized water, in order to avoid salt deposits in the heat pipes.

"Alcohol" in the meaning of the present invention is a type of organic compound that carries at least one hydroxyl (-OH) functional group bound to a saturated carbon atom. According to one embodiment of the present invention the alcohol is selected from the

group consisting of methanol, ethanol, propanol, butanol pentanol, hexanol and mixtures thereof. Such alcohols can be used as working fluid in heat pipes for applications requiring lower operating temperatures, such as in cold environments. Ethanol and methanol have lower boiling points than water, making them suitable for applications ranging from -100°C to 78°C. Even if they are flammable, they offer good thermal performance and are relatively easy to handle.

"Ketones" in the meaning of the present invention are an organic compound with the structure R-C(=O)-R', where R and R' can be a variety of carbon-containing substituents. Ketones contain a carbonyl group -C(=O)-, also known as a carbon-oxygen double bond C=O. According to one embodiment of the present invention the ketones are selected from the group consisting of acetone, methyl ethyl ketone, methyl propyl ketone, diethyl ketone, cyclohexanone, 2-hexanone, 3-hexanone and mixtures thereof. Such ketones can be used as working fluid in heat pipes for applications requiring lower operating temperatures, such as in cold environments. Acetone has a lower boiling point than water, making it suitable for applications ranging from 95°C to 56°C. Even if they are flammable, they offer good thermal performance and are relatively easy to handle. "Fluorocarbons" in the meaning of the present invention are chemical compounds with carbon-fluorine bonds. According to one embodiment of the present invention, the fluorocarbons comprise only perfluorocarbons, also known as PFCs. PFCs in the meaning of the present invention are organofluorine compounds with the formula CₓF_{y}, meaning they contain only carbon and fluorine. According to another embodiment of the present invention, the fluorocarbons are selected from the group consisting of perfluoroalkanes, fluoroalkenes, fluoroalkynes, perfluoroaromatic compounds and mixtures thereof. According to a preferred embodiment of the present invention, the fluorocarbons are selected from the group consisting of perfluoromethane, perfluorohexane, perfluoropentane, perfluorobutane, perfluorooctane, perfluorodecalin, perfluoromethylcyclohexane, ferfluorotoluene, perfluoro-1,3-dimethylcyclohexane and mixtures thereof. Such fluorocarbons can be used as working fluid in heat pipes in specialized applications where chemical inertness and stability are required, such as in aerospace or in specialty electronic cooling. They have a wide range of boiling points, allowing for flexibility in temperature applications. Even if they might be expensive and may have environmental concerns, they offer excellent thermal stability and are non-flammable.

According to one embodiment of the present invention mixtures of the above working fluids are used to tailor the boiling and condensation characteristics to specific application needs. This approach allows for fine-tuning of the heat pipe's performance across a broader temperature range.

The amount of working fluid used in a heat pipe contributes to its efficient operation. The skilled person knows how to optimize the amount of working fluid based on the volume of the enclosed interior space and/or the hydrophilicity of the fiberglass braided sleeve. The amount of working fluid must be sufficient to maintain a continuous cycle of vaporization and condensation without leaving any section of the heat pipe dry. Generally, only a few microliters of working fluid are required, but this can vary depending on the size and design of the heat pipe. The skilled person must ensure that the amount of working fluid is balanced to provide optimal thermal management without overfilling, which could impede the capillary action and reduce efficiency.

According to one embodiment of the present invention the working fluid is present in the heat pipe in an amount of 0.005 µl/mm³ to 5.0 µl/ mm³, preferably in an amount of 0.010 µl/mm³ to 1.0 µl/mm³, even more preferably 0.015 µl/mm³ to 0.80 µl/mm³ and most preferably in an amount of 0.020 µl/mm³ to 0.50 µl/mm³.

The inventors surprisingly found that the inventive heat pipes have a good thermal management. The inventors surprisingly found that due to the innovative materials and design, especially the fiberglass braided sleeve, the inventive heat pipes perform similar or even more effectively than the existing ones, when having the same or similar or even smaller proportions. According to one embodiment of the present invention, the heat pipe according to the present invention has a thermal conductivity of 0.2 W/mK, preferably of 0.5 W/mK, even more preferably of 0.8 W/mK and most preferably of 1.0 W/mK. The skilled person knows how to measure the thermal conductivity of a heat pipe. Devices for measuring the thermal conductivity are commercially available.

The inventors surprisingly found that the inventive heat pipe according to the present invention has several significant advantages over heat pipes that are already known and commercially available, especially in applications requiring efficient thermal management of electronic components.

First of all, the inventive heat pipes that can be used instead of the existing heat pipes known in the prior art. The heat pipes of the present invention are lightweight, robust, chemically inert and non-toxic or hazardous and environmentally friendly. Especially the use of glass as material for the glass tubular body and the fiberglass braided sleeve results in a heat pipe that is both flexible and lightweight. This flexibility allows the heat pipe to be used in applications where traditional rigid metal heat pipes would be unsuitable, such as in foldable or rollable devices. The lightweight nature of the materials also contributes to the overall reduction in device weight, which is a critical factor in portable and wearable electronics.

Furthermore, due to the design and the material of the glass tubular body and the fiberglass braided sleeve, excellent vacuum/reduced pressure integrity and thermal stability is provided, essential for maintaining the low-pressure environment required for efficient heat transfer. Unlike plastic alternatives, which may lack mechanical stability under high vacuum conditions, the glass material ensures that the heat pipe remains functional and reliable over a wide range of operating temperatures. Furthermore, the glass material is chemically inert to the working fluid and prevents evaporation over time.

The materials used in the present invention are generally more environmentally friendly compared to other materials regularly used in heat pipes of the prior art. Glass materials are non-toxic compared to several metal and plastic alternatives and can reduce environmental pollution, especially when used instead of plastic alternatives. Additionally, the manufacturing process for glass and fiberglass components can be more cost-effective, particularly when considering the long-term reliability and performance benefits.

A further advantage of the present invention is the non-conductive design, achieved through the use of a glass tubular body and a fiberglass braided sleeve. According to a preferred embodiment of the present invention, the heat pipe does not comprise any metal component. Due to the reduced amount of metal or even the absence of metals in the inventive heat pipe, they can be used in electronic devices. Traditional metal heat pipes, such as those made from copper, are excellent conductors of heat but also conduct electricity, which can interfere with electromagnetic signals in sensitive electronic environments. The non-conductive nature of the materials used in this invention reduces or even eliminates such interference, making it ideal for applications where electromagnetic compatibility is crucial, such as in electronic devices, especially in wearable devices and portable electronics.

### Method for preparing the heat pipe

According to one embodiment of the present invention, a method for preparing the inventive heat pipe is provided. The method for preparing the heat pipe comprises the steps of
A) providing a glass tube with a first open end and a second open end and a transfer section,
B) providing a fiberglass braided sleeve, wherein the fiberglass braided sleeve comprises strands of fiberglass spirally woven in the longitudinal direction of the sleeve,
C) providing a working fluid,
D) inserting the fiberglass braided sleeve of step B) into the glass tube of step A),
E) closing thermally the first open end of the glass tube, to obtain a one end closed glass tube,
F) inserting the working fluid of step C) in the one end closed glass tube of step E) and evacuating the glass tube afterwards to obtain a filled glass tube and
G) closing thermally the second end of the filled glass tube of step F).

According to step A) a glass tube with a first open end and a second open end and a transfer section is provided, according to step B) a fiberglass braided sleeve is provided and according to step C) a working fluid is provided. These components have already been described in detail above and the features and embodiments described above also apply to the method described herein.

According to step D) the fiberglass braided sleeve of step B) is inserted into the glass tube of step A). This method step requires precision to ensure that the sleeve is evenly distributed within the tube and does not twist or bunch up or has poolings. Furthermore, one has to ensure that during inserting the individual fibers in the bundles of fibers in the stands of the fiberglass braided sleeve are not bent or otherwise damaged, since this would result in an impairment of the fibers/the fiberglass braided sleeve and might result in a reduction of the cooling efficacy of the inventive heat pipe. Furthermore, one has to ensure that the fiberglass braided sleeve after inserting into the glass tube is completely inside the glass tube and neither protrudes at the ends of the glass tube to prevent problems such as inclusions or incorrect sealing when the ends of the glass tube are closed. The skilled person knows how to handle the fiberglass braided sleeve and insert it into the glass tube. This can be done, for example by inserting it manually, or by inserting it via a machine. The insertion can be facilitated using a guiding rod or a similar tool to maintain alignment.

According to a preferred embodiment of the present invention the diameter of the fiberglass braided sleeve provided in step B) is larger than the diameter of the transfer section of the glass tube provided in step A). During inserting step D), the fiberglass braided sleeve is pulled slightly apart at both ends. Due to the flexible shape of the fiberglass braided sleeve, the diameter of the fiberglass braided sleeve becomes smaller as long as the tensile force is applied to the fiberglass braded sleeve. Preferably, the tensile force that is applied at both ends of the fiberglass braided sleeve is so high that the diameter of the stretched fiberglass braided sleeve is smaller than the inner diameter of the transfer section of the glass tube. In such a case the fiberglass braided sleeve can be easily inserted into the glass tube. When positioned inside the glass tube the tensile force that is applied at both ends of the fiberglass braided sleeve is no longer applied and the fiberglass braided sleeve relaxes and tries to expand to its original size, especially to its original diameter. In case the inner diameter of the transfer section of the glass tube is smaller than the diameter of the fiberglass braided sleeve, the fiberglass braided sleeve can only expand up to the inner diameter of the glass tube. In that situation the fiberglass braided sleeve actively presses against the inside of the glass tube, fixing it in the inserted position. This is particularly beneficial as it prevents the fiberglass braided sleeve from slipping or falling out of the glass tube during further processing.

According to step E) the first open end of the glass tube is thermally closed to obtain a one end closed glass tube. This step can be done directly before step D) or directly after step D). More precisely, according to one embodiment the fiberglass braided sleeve of step B) is inserted into the glass tube of step A), and afterwards the first open end of the glass tube is closed thermally. According to another embodiment, the first open end of the glass tube is closed thermally, and afterwards the fiberglass braided sleeve is inserted into the glass tube from the second end. However, according to a preferred embodiment the present invention, the fiberglass braided sleeve of step B) is inserted into the glass tube of step A), and afterwards the first open end of the glass tube is closed thermally, which means that step D) is performed before step E).

In order to close the first open end thermally, the first end is heated up to a temperature wherein the glass is softened, and the softened end is closed either with a forming tool to physically form the closure or the softened end falls in on itself due to gravity, thereby closing off the first end of the glass tube. According to a preferred embodiment of the present invention, the softened end is closed with a forming tool. Preferably the glass tube is rotated around the circumferential axis of the glass tube during closing in order to improve the closing process.

The heating can be done, for example, with a gas burner, a laser or a plasma burner. The skilled person knows these different methods and will choose the heating device, dependent on the available equipment and the glass material of the glass tube. According to a preferred embodiment, the heating is done with a gas burner.

The skilled person knows to what temperature the glass tube has to be heated in order to soften the glass of the glass tube. According to a preferred embodiment of the present invention, the thermally closing of the first open end of the glass tube, to obtain a one end closed glass tube, is done preferably at a temperature in the range of 1300 to 1700°C and even more preferably at a temperature in the range of 1400 to 1600 °C.

According to step F) the working fluid of step C) is inserted in the one end closed glass tube of step E) and afterwards the glass tube is evacuated to obtain a filled glass tube. The fiberglass braided sleeve and the working fluid are not removed during evacuation. Inserting of the working fluid into the one end closed glass tube is done, for example, via poring, syringes, pipettes, droppers, pumps, injectors or similar devices. The skilled person knows these devices and will choose a device dependent on the available equipment and the amount of working fluid that has to be inserted. This can be done, for example by inserting it manually, or by inserting it via a machine.

"Evacuating" in the meaning of the present invention refers to the process of removing air or other gases from the inside of the glass tube to create a vacuum or at least a reduced pressure inside the glass tube once the second end of the glass tube is closed. The skilled person knows how to evacuate tubes, for example, by vacuum pumps, steam ejectors, venturi vacuum generators, oil-free diaphragm pumps or handheld vacuum sealers. The skilled person chooses the device dependent on the available equipment and the pressure that should be obtained.

According to a preferred embodiment of the present invention the glass tube is evacuated to a pressure of below 100 Pa, preferably below 1.0 Pa, more preferably below 0.1 Pa, even more preferably below1*10⁻⁶ Pa and even more preferably below 1*10⁻⁹ Pa. According to a preferred embodiment the working fluid of step C) is inserted in the one end closed glass tube of step E), and evacuating of the glass tube afterwards to obtain a filled glass tube is done at reduced temperature.

A "reduced temperature" in the meaning of the present invention is a temperature that is below the room temperature. The room temperature is defined as a temperature of 20 °C at an atmospheric pressure of 101,325 Pa (1,013.25 hPa).

According to a preferred embodiment the working fluid of step C) is inserted in the one end closed glass tube of step E) and afterwards, the one end closed glass tube with the working fluid is freezed such that the working fluid is not liquid anymore but solid. Afterwards the glass tube is evacuated, but the evacuation of the glass tube is done during the working fluid is still solid. The skilled person knows the temperature at which the working fluid freezes and gets solid, for example, water freezes at 0 °C. The freezing of the working fluid can be done with different devices and methods, for example by cooling with ice bath, refrigeration or cryogenic cooling. The skilled person chooses the device/method dependent on the available equipment and the temperature at which the working fluid freezes.

According to one embodiment the working fluid of step C) is inserted in the one end closed glass tube of step E), cooled to a temperature of below 0 °C, preferably below - 70°C, even more preferably below -95°C even more preferably below -98 °C and most preferably below -114°C and afterwards the glass tube is evacuated during the working fluid is solid to obtain a filled glass tube.

Alternatively, evacuation of the one end closed glass tube is done before inserting the gas free working fluid into the evacuated one end closed glass tube.

According to step G) the second end of the filled glass tube of step F) is closed thermally.

In order to close the second open end thermally, the second end is heated up to a temperature wherein the glass is softened, and the softened end is closed either with a forming tool to physically form the closure or the softened end falls in on itself due to gravity, thereby closing off the second end of the glass tube. According to a preferred embodiment of the present invention, the softened end is closed with a forming tool. Preferably the glass tube is rotated around the circumferential axis of the glass tube during closing in order to improve the closing process.

The heating can be done, for example, with a gas burner, a laser or a plasma burner. The skilled person knows these different methods and will choose the heating device, dependent on the available equipment and the glass material of the glass tube. According to a preferred embodiment, the heating is done with a gas burner.

The skilled person knows to what temperature the glass tube has to be heated in order to soften the glass of the glass tube. According to a preferred embodiment of the present invention, the thermally closing of the first open end of the glass tube, to obtain a one end closed glass tube, is done preferably at a temperature in the range of 1300 to 1700°C and even more preferably at a temperature in the range of 1400 to 1600 °C. Closing of the second end of the glass tube is done such that the vacuum or the reduced pressure that has been created during step F) is maintained. According to a preferred embodiment of the present invention, closing of the second end of the glass tube is done during evacuation of the filled glass tube obtained after step F).

According to a preferred embodiment of the present invention the glass tube is evacuated to a pressure of below 100 Pa, preferably below 1.0 Pa, more preferably below 0.1 Pa, even more preferably below1*10⁻⁶ Pa and even more preferably below 1*10⁻⁹ Pa. According to a preferred embodiment evacuation of the filled glass tube obtained after step F) is done at reduced temperature. According to a preferred embodiment of the present invention, the filled glass tube obtained after step F) is freezed such that the working fluid is not liquid anymore but solid. Afterwards the glass tube is evacuated, but the evacuation of the glass tube is done during the working fluid is still solid and finally, the second end of the filled glass tube of step F) is closed thermally.

### Additional process steps:

It is preferred that the inside of the glass tube and the fiberglass braided sleeve are free of impurities and contaminations, especially free of particles such as dust particles or glass particles, and free of organic impurities such as glycerin or grease or starch deposits that might be present on the fiberglass braided sleeve. In order to clean the glass tube and/or the fiberglass braided sleeve it is possible to wash them prior to use with water or organic solvents and/or to heat them in order to burn such impurities and contaminations.

According to another embodiment of the present invention, an alternative method for preparing the inventive heat pipe is provided. The alternative method for preparing the heat pipe comprises the steps of
I) providing a glass tube preform,
II) providing a fiberglass braided sleeve preform,
III) providing a working fluid,
IV) inserting the fiberglass braided sleeve preform of step II) into the glass tube preform of step I),
V) cutting the glass tube preform with the inserted fiberglass braided sleeve preform of step IV) to obtain a glass tube with a first open end and a second open end and a transfer section, and a fiberglass braided sleeve inserted into the glass tube,
VI) closing thermally the first open end of the glass tube, to obtain a one end closed glass tube,
VII) inserting the working fluid of step III) in the one end closed glass tube of step VI) and evacuating the glass tube afterwards to obtain a filled glass tube and
VIII) closing thermally the second end of the filled glass tube of step VII).

A "preform" in the meaning of the present invention is a glass tube or fiberglass braided sleeve as described above with the exception that it is longer and can be cut, for example by thermal cutting or laser cutting, to obtain the glass tube or fiberglass braided sleeve.

The inventors found that the inventive heat pipes are easy to manufacture. It is especially, that standard equipment can be used, and no specialized equipment has to be provided. Furthermore, since the components that are used for preparing the inventive heat pipe are generally more environmentally friendly compared to other materials regularly used in heat pipes of the prior art, and preferably are non-toxic or hazardous, there are no increased safety requirements and environmental conditions in the production of the inventive heat pipes. Therefore, the present method is on the one hand environmentally friendly and on the other hand also economically advantageous.

Additionally, the manufacturing process for glass and fiberglass components can be more cost-effective, particularly when considering the long-term reliability and performance benefits and, therefore, the heat pipes of the present invention are inexpensive. In addition, the simple components and uncomplicated method enables a stable production, which is reflected in significantly lower scrap rates. Furthermore, the performance of the heat pipe can be specifically adjusted using the individual components.

Furthermore, a heat pipe is provided comprising a) a glass tubular body comprising a first closed end, a second closed end and a transfer section, wherein the inner surface of the tubular body encloses an interior space, b) a fiberglass braided sleeve within the enclosed interior space of the tubular body, wherein the fiberglass braided sleeve comprises strands of fiberglass spirally braid-ed in the longitudinal direction of the sleeve, and c) a working fluid in the enclosed interior space of the tubular body, obtained by a method comprising the steps of A) providing a glass tube with a first open end and a second open end and a transfer section, B) providing a fiberglass braided sleeve, wherein the fiberglass braided sleeve comprises strands of fiberglass spirally woven in the longitudinal direction of the sleeve, C) providing a working fluid, D) inserting the fiberglass braided sleeve of step B) into the glass tube of step A), E) closing thermally the first open end of the glass tube, to obtain a one end closed glass tube, F) inserting the working fluid of step C) in the one end closed glass tube of step E) and evacuating the glass tube afterwards to obtain a filled glass tube and G) closing thermally the second end of the filled glass tube of step F).

By the above method a functional heat pipe is prepared, that can be used in thermal management applications for cooling and especially for cooling electronic components.

### Use of the heat pipe

According to one embodiment of the present invention, the inventive heat pipe can be used for cooling.

"Cooling" in the meaning of the present invention refers to transferring heat from one location that is in direct or indirect contact with the first closed end of the heat pipe away from this location via the heat pipe. By transferring the heat away from that location, the overall temperature of that location can be actively controlled. However, this does not mean that the temperature of that location cannot rise, for example in case the location is at a point where heat is generated, e.g. by an electronic component. In such a case the electronic component might release heat, and the temperature of the location is rising. However, the temperature increase in such a case is lower than without the inventive heat pipe.

A "direct contact" of one location with the first closed end in the meaning of the present invention refers to a situation where the location is in physical touch with the first closed end allowing heat to be transferred directly to the first closed end. An "indirect contact" of one location with the first closed end in the meaning of the present invention refers to a situation where the location is not directly in physical touch with the first closed end but by an intermediary medium such as thermal paste, air, gas or a liquid like water, allowing heat to be transferred via this intermediary medium to the first closed end.

"Heat" in the meaning of the present invention is a form of energy that can be transferred between systems or objects due to a temperature difference. If not indicated otherwise, the temperature in the present invention refers always to values in °C. The skilled person knows how to measure the temperature and also the temperature difference, for example, by thermometer.

According to a preferred embodiment of the present invention, the inventive heat pipe is used for cooling electronic components. An electronic component or electronic device in the meaning of the present invention is any component or device that operates using electrical power and relies on the flow of electric current to perform specific functions. These devices or components often comprise structural elements like circuits, sensors, (micro)processors, memory, input/output interfaces, and/or communication interfaces, which may be communicatively coupled to one another by way of a communication infrastructure (e.g., a bus, traces, wires, etc.). The above structural elements can be rearranged, combined, and/or omitted depending on the requirements for a particular application or function. The electronic components or electronic devices may comprise additional or alternative structural elements.

In some examples, the circuit may include various components such as resistors, capacitors, and transistors. When the circuit is complete, electricity can flow through it without interruption.

In some examples, the sensor might be, for example, a temperature sensor, a proximity sensor, a light sensor, a pressure sensor, a motion sensor, a humidity sensor, or a gas sensor. Such a sensor can detect and responds to some type of input from the physical environment, wherein the specific input could be light, heat, motion, moisture, pressure, or any other environmental phenomena, and the sensor might then convert this input into a readable signal, which can be measured and recorded.

In some examples, the (micro)processor may include hardware for executing instructions, for example a computer program or application. Instructions may be sent from an internal register, an internal cache, the memory, or other computer-readable media to the (micro)processor and executed by them. The (micro)processor may comprise one or more central processing units (CPUs), graphics processing units (GPUs), holographic processing units, microcontrollers, programmable gate arrays, or other hardware components usable to execute instructions.

In some examples, the memory may include internal and/or distributed memory as well as removable and/or non-removable storage, for example non-transitory computer-readable media, such as Random-Access Memory ("RAM"), Read-Only Memory ("ROM"), a solid state disk ("SSD"), Flash, Phase Change Memory ("PCM"), or other types of data storage, for example, hard disk drives (HDDs), flash memory, Universal Serial Bus (USB) drives, or a combination thereof. The memory may be a computer-readable media and can be communicatively coupled to the (micro)processor for storing data, metadata, and programs for execution by the (micro)processor. The memory may store applications such as operating systems, productivity applications, communication applications, games, or the like and might be implemented as a stand-alone application, a module of an application, plug-ins, library functions application programming interfaces (APIs), and/or as a cloud-computing model. These applications can include local applications, web-based applications, and/or mobile device applications also known as "apps".

In some examples, the electronic components might comprise one or more input/output interfaces, which allow the user to provide input to and receive output from the electronic components. Such input interfaces might be, for example, keyboards or keypads, mice, styluses, touch screens (that might be activated with a stylus, finger, thumb, or other object), cameras, microphones, accelerometers, gyroscopes, inertial measurement units, optical scanners, other sensors, controllers (e.g., handheld controllers, remote controls, gaming controllers, etc.), network interfaces, modems, or a combination of such input interfaces. Such output interfaces might be, for example, a graphics engine, a display (e.g., a display screen, projector, holographic display, etc.), output drivers (e.g., display drivers), audio speakers, or audio drivers.

In some examples, the electronic components might comprise a communication interface, including hardware, software, or both, especially for physical and/or logical communication between the electronic components and further structural elements. For example, the communication interface might be a network interface controller (NIC) or network adapter for communicating with an Ethernet or other wire-based network and/or a wireless NIC (WNIC) or wireless adapter for communicating with a wireless network, such as a WI-FI adapter.

As already set out above, the electronic components or electronic devices may comprise additional or alternative structural elements. Such components might be, for example, a power supply (e g., batteries, capacitors, etc.), a housing or other enclosure to at least partially house or enclose any or all of these components.

According to one embodiment of the present invention, the inventive heat pipe is used in a wearable device, a portable device, a mobile device or a rollable or foldable device.

A wearable device in the meaning of the present invention is a device that is designed to be worn on the body, often incorporating sensors and connectivity features for health monitoring, communication, or augmented reality. According to a preferred embodiment of the present invention, the wearable device is a watch, a haptic feedback glove, a wristband, a belt, an armband, or a head-mounted device, preferably an extended reality headset or glasses.

A portable device in the meaning of the present invention is a device designed for mobility to be transported to different locations, and includes, for example, laptops or tablets. According to a preferred embodiment of the present invention, the portable device is a laptop computer.

A mobile device in the meaning of the present invention is a device that comprises a mobile connection, enabling them to access cellular networks for internet connectivity, communication, and other functions. They are often equipped with touchscreens and various sensors, allowing users to run applications, browse the web, and stay connected from virtually anywhere. According to a preferred embodiment of the present invention, the mobile device is a tablet or mobile phone.

A rollable or foldable device in the meaning of the present invention is a device with flexible display and form factors, that can be compressed/minimized by folding or rolling. According to a preferred embodiment of the present invention, the rollable or foldable device is a foldable phones or e-reader.

According to a preferred embodiment of the present invention the inventive heat pipe is used in wearable devices, preferably a watch, a haptic feedback glove, a wristband, a belt, an armband, head-mounted devices, preferably an extended reality headset or glasses, portable devices, preferably a laptop computer, mobile devices, preferably a tablet or mobile phone, rollable or foldable devices, preferably foldable phones or e-readers.

According to an exemplified embodiment of the present invention, the inventive heat pipe is used in a wearable device, preferably a head-mounted device, and most preferably in an extended reality headset or in glasses. Such an extended reality headset or such glasses often comprise an input/output interface that is configured to provide an extended reality environment or other computer-generated environment to the user. An extended reality environment includes an at least partially computer-generated environment, such as virtual reality, augmented reality, and/or mixed reality, and extended reality devices or headsets are devices configured to provide all or a portion of an extended reality environment.

The inventors found that the heat pipes of the present invention have several advantages that makes them ideal for cooling, especially in such electronic components, as already set out above.

Furthermore, the design of the present invention allows for its use in a wide range of applications, especially from cooling electronic components in compact devices to managing heat in larger systems. This versatility is a significant advantage over prior art, which may be limited to specific applications due to material or design constraints.

In summary, the present invention addresses the limitations of existing heat pipe technologies by providing a solution that is both efficient in heat transfer and compatible with sensitive electronic environments. Its non-conductive, flexible, and lightweight design, combined with enhanced capillary action and vacuum or reduced pressure integrity, makes it a superior choice for modern electronic applications.

Although the present invention has been described with reference to preferred examples of embodiments, it is not limited thereto but can be modified in a variety of ways.

### List of reference numerals

- 100: sealed pipe
- 102: vaporization zone
- 103: transportation zone
- 104: condensation zone
- 105: fluid
- 106: vapor flow
- 107: recirculation of fluid
- 200: glass tubular body
- 201: fiberglass braided sleeve
- 202: first closed end
- 203: transfer section
- 204: second closed end
- 205: working fluid
- 206: fluid transport by the fiberglass braided sleeve
- 207: recirculation of fluid
- 208: strand of fiberglass fibers
- 209: fiberglass fiber
- 210: braiding axis

- α: braiding angle

## Claims

1. Heat pipe comprising
a) a glass tubular body comprising a first closed end, a second closed end and a transfer section, wherein the inner surface of the tubular body encloses an interior space,
b) a fiberglass braided sleeve within the enclosed interior space of the tubular body, wherein the fiberglass braided sleeve comprises strands of fiberglass spirally braided in the longitudinal direction of the sleeve, and
c) a working fluid in the enclosed interior space of the tubular body.

2. Heat pipe according to claim 1, wherein at least a part of the fiberglass braided sleeve is in contact with the inner surface of the tubular body, preferably at least 40 % of the inner surface of the transfer section are in contact with the fiberglass braided sleeve, more preferably at least 60 %, and most preferably at least 80%.

3. The heat pipe according to any of the preceding claims, wherein the glass tubular body
i) has a ratio of diameter to length from 1:2.0 to 1:100, preferably from 1:2.5 to 1:80, more preferably from 1:5.0 to 1:60 and/or
ii) has an oval or round profile and preferably has a round profile.

4. The heat pipe according to any of the preceding claims, wherein the strands of the fiberglass braided sleeve comprise bundles of fibers preferably comprise at least 50 fibers, more preferably at least 100 fibers and most preferably at least 200 fibers and/or wherein the fibers have a diameter of 1 µm to 20 µm, preferably 2 µm to 15 µm and most preferably 3 µm to 10 µm.

5. The heat pipe according to any of the preceding claims, wherein the fiberglass braided sleeve has a braiding angle between 30° to 80°, preferably between 40° to 60° and most preferably between 42° to 50°.

6. The heat pipe according to any of the preceding claims, wherein
i) the fiberglass braided sleeve has a torque of at least 0.1 cm/min, preferably at least 0.2 cm/min, more preferably at least 0.3 cm/min even more preferably 0.4 cm/min and most preferably 0.5 cm/min and/or
ii) the fiberglass braided sleeve has a maximal torque of at least 5 cm, preferably at least 10 cm, even more preferably at least 15 cm and most preferably at least 20 cm.

7. The heat pipe according to any of the preceding claims, wherein the enclosed interior space in the glass tubular body is vacuumed and has a pressure of below 100 Pa, preferably below 1.0 Pa, more preferably below 0.1 Pa, even more preferably below1*10⁻⁶ Pa and even more preferably below 1*10⁻⁹ Pa.

8. The heat pipe according to any of the preceding claims, wherein the working fluid
i) is selected from water, alcohols, ketones, fluorocarbons and mixtures thereof, preferably is selected from water, ethanol, methanol, perfluorocarbons and mixtures thereof and/or
ii) is present in the heat pipe in an amount of 0.005 µl/mm³ to 5.0 µl/ mm³, preferably in an amount of 0.010 µl/mm³ to 1.0 µl/mm³, even more preferably 0.015 µl/mm³ to 0.80 µl/mm³ and most preferably in an amount of 0.020 µl/mm³ to 0.50 µl/mm³.

9. The heat pipe according to any of the preceding claims, wherein the heat pipe does not comprise any metal component.

10. The heat pipe according to any of the preceding claims, wherein the heat pipe has a thermal conductivity of 0.2 W/mK, preferably of 0.5 W/mK, even more preferably of 0.8 W/mK and most preferably of 1.0 W/mK.

11. Method for preparing the heat pipe according to any of the preceding claims comprising the steps of
A) providing a glass tube with a first open end and a second open end and a transfer section,
B) providing a fiberglass braided sleeve, wherein the fiberglass braided sleeve comprises strands of fiberglass spirally woven in the longitudinal direction of the sleeve,
C) providing a working fluid,
D) inserting the fiberglass braided sleeve of step B) into the glass tube of step A),
E) closing thermally the first open end of the glass tube, to obtain a one end closed glass tube,
F) inserting the working fluid of step C) in the one end closed glass tube of step E) and evacuating the glass tube afterwards to obtain a filled glass tube and
G) closing thermally the second end of the filled glass tube of step F).

12. The method of claim 11, wherein the diameter of the fiberglass braided sleeve provided in step B) is larger than the diameter of the transfer section of the glass tube provided in step A).

13. Use of the heat pipe according to claims 1 to 10 for cooling, preferably for cooling of electronic components.

14. Use of the heat pipe according to claim 13 in wearable devices, preferably a watch, a haptic feedback glove, a wristband, a belt, an armband, head-mounted devices, preferably an extended reality headset or glasses, portable devices, preferably a laptop computer, mobile devices, preferably a tablet or mobile phone, rollable or foldable devices, preferably foldable phones or e-readers.
